# EUROPEAN PATENT SPECIFICATION

(11) **EP 0 473 877 B1**
(45) Date of publication and mention of the grant of the patent: **17.07.1996**
(21) Application number: 91106470.7
(22) Date of filing: 22.04.1991
(51) Int. Cl.: G01R 21/133, G01R 21/06, G01R 15/00

(54) **Sampling type measuring device**
Abtastende Messeinrichtung
Dispositif de mesure du type à sondage

(30) Priority: 23.08.1990 JP 222100/90; 24.08.1990 JP 222722/90; 27.08.1990 JP 224915/90
(43) Date of publication of application: 11.03.1992
(73) Proprietor: Yokogawa Electric Corporation, Tokyo 180 (JP)
(72) Inventor: Kashiwabara, Yukio, Fussa-shi, Tokyo, 197 (JP); Hiraishi, Yukiyoshi, Kawasaki-shi, Kanagawa, 251 (JP); Goto, Eiichi, Kofu-shi, Yamanashi, 400 (JP)
(74) Representative: Henkel, Feiler, Hänzel & Partner

(56) References cited:
- EP-A- 0 043 958
- AU-D- 3 513 284
- DE-A- 3 045 033
- DE-A- 3 620 484

## Description

### BACKGROUND OF THE INVENTION

### Field of the Invention

This invention relates to a sampling type measuring device which measures an analog input signal by performing sampling on the analog input signal at a certain period, converting each value picked up by sampling into digital form, and processing the digital values.

### Description of the Prior Art

The prior art will be described taking a sampling type wattmeter as an example.

In conventional wattmeters, such as AU-B-35132/84, an effective power value is obtained by performing sampling on an input voltage waveform and an input current waveform by the use of analog-digital converters ( referred to as AD converter ) ( for converting an analog signal into digital form ), and multiplying the thus sampled values together.
Therefore, the obtained power value involves an error if the integral multiple of one cycle of the input waveform is out of accord with the integral multiple of a sampling period.

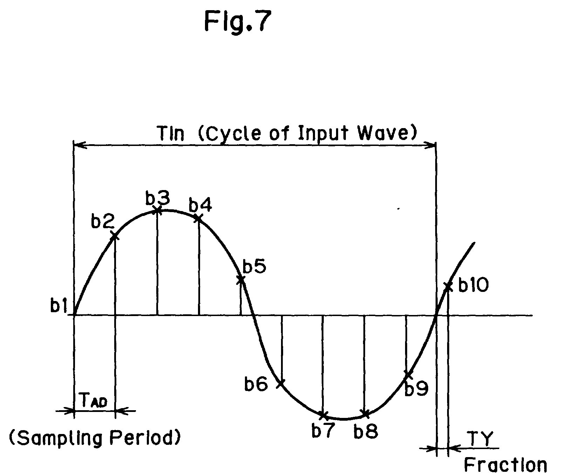

The reason why an error is involved will be described with reference to Fig. 7. In conventional sampling type wattmeters, the effective power value W ( the mean value of instantaneous power values, Vn · In ) is obtained by performing the following arithmetic averaging calculation: 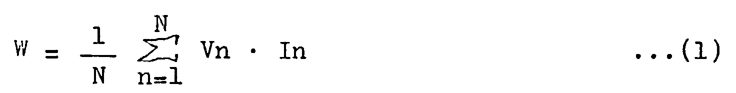 where Vn is the sampled value of the input voltage, In is the sampled value of the input current, and N is the sampling number ( the number of sampling actions ).

In the waveform shown in Fig. 7, one cycle Tin of the input waveform is out of accord with the integral multiple of a sampling period T_{AD}, that is, 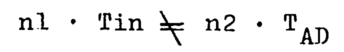 (n1 = 1, 2, 3,... , and n2 = 3, 4, 5,...) However, there is the relationship: n2 ≧ 2n1 + 1. This condition is for the purpose of preventing the operation of sampling the input waveform at identical phase positions. Therefore, a fraction TY appears as shown in Fig. 7. This fraction TY causes a corresponding error in the effective power value W obtained by performing the arithmetic averaging calculation ( of Equation (1) ).

Similarly to the case of power measurement, in the operation of measuring the mean value of rectified waveform, or effective value of an analog input signal by sampling, if a fraction such as "TY" shown in Fig. 7 appears, there arises a corresponding error.

To lighten an influence due to the fraction TY, the following methods are known:
(1) To regulate the sampling period T_{AD} relative to the input waveform such that n1 · Tin = n2 · T_{AD}.
(2) To perform sampling on the input signal or waveform over several cycles until the relationship: n1 · Tin = n2 · T_{AD} is reached.
(3) To shorten the sampling period T_{AD} to decrease the fraction TY relative to one cycle Tin of the input waveform very much, thereby decreasing an error.
(4) To increase the sampling number N ( see Equation (1) ) to relatively decrease the influence of the fraction TY.

The foregoing four methods, however, have the following disadvantages:
(1) In the first method, a phase-locked circuit for regulating the sampling period T_{AD} must have a wide frequency-variable range; thus, the circuit configuration becomes complicated, leading to high costs.
(2) In the second method, measurement cannot be done before an interval corresponding to the integral multiple of one cycle Tin of the input waveform comes into accord with that corresponding to the integral multiple of the sampling period T_{AD}; thus, the response time of measurement becomes long.
(3) In the third method, an AD converter must be of the high speed type in order to successively process the values picked up at short intervals; thus, the circuit cost increases.
(4) In the fourth method, where the input waveform changes from one value W1 to another W2, the second value W2 cannot be measured quickly in time.

The reason of the above defect will be described taking the condition that an effective power value W1 has been obtained by processing, in accordance with Equation (1), 1000 values picked up by 1000 sampling actions. In this case, if the input waveform changes to a different value W2 after the sampling number reaches 1000, the then calculated value cannot easily reach the new value W2 because the influence of the sum of the values corresponding to the first to thousandth sampling actions is significant. That is, since the sum of the values corresponding to the first to thousandth sampling actions is very large, even when the then sampled values corresponding to the thousandth and first and subsequent sampling actions are added to the last sum in Equation (1), the sum (Σ) changes little; thus, a large number of sampling actions must be performed until the new value W2 is actually calculated.

### SUMMARY OF THE INVENTION

It is a first object of the present invention to provide a sampling type measuring device capable of accurately measuring an analog input signal without the need to regulate a sampling period T_{AD}.

It is a second object of the present invention to provide a sampling type measuring device capable of quick measurement without waiting for an interval corresponding to the integral multiple of one cycle Tin of an input waveform to come into accord with that corresponding to the integral multiple of a sampling period T_{AD}.

It is a third object of the present invention to provide a sampling type measuring device capable of measuring an analog input signal without the need for a high-speed analog-digital converter.

It is a fourth object of the present invention to provide a sampling type measuring device capable of measuring a new value of a measurement signal comparatively quickly.

Each sampled value is processed in arithmetic units, such as multiplier, absolute value arithmetic unit, and square arithmetic unit, to provide a corresponding digital value. The thus obtained digital value represents the instantaneous value of a measurement signal ( a signal to be measured ), thus varies from sampling moment to moment in conformity with the measurement signal. To attain accurate measurement, it is necessary to calculate the mean value of instantaneous values. According to the present invention, these instantaneous values ( in digital form ) are applied directly to an averaging means. This averaging means provides the mean value of these instantaneous values by repeatedly performing exponential averaging calculation a certain number of times.

### BRIEF DESCRIPTION OF THE DRAWINGS

Fig. 1 is a block diagram showing an embodiment of a sampling type measuring device according to the present invention which is embodied in the form of a wattmeter;
Fig. 2 is a waveform diagram showing signal waveforms at several points in the device shown in Fig. 1;
Fig. 3 is a schematic diagram showing an embodiment of an averaging means;
Fig. 4 is a schematic diagram showing another embodiment of the averaging means;
Fig. 5 is a timing diagram showing a relationship between calculated mean value and display moment;
Fig. 6 is a timing diagram showing another relationship between calculated mean value and display moment;
Fig. 7 is a waveform diagram explanatory of the cause of error generation;
Fig. 8 is a block diagram showing another embodiment of the sampling type measuring device according to the present invention which is embodied in the form of a mean value rectifying type measuring device;
Fig. 9 is a waveform diagram showing signal waveforms at several points in the device shown in Fig. 8;
Fig. 10 is a block diagram showing still another embodiment of the sampling type measuring device according to the present invention which is embodied in the form of an effective value measuring device;
Fig. 11 is a waveform diagram showing signal waveforms at several points in the device shown in Fig. 10; and
Fig. 12 is a schematic diagram showing still another embodiment of the averaging means.

### DETAILED DESCRIPTION OF THE PREFERRED EMBODIMENTS

The present invention will now be described in greater detail with reference to the drawings.

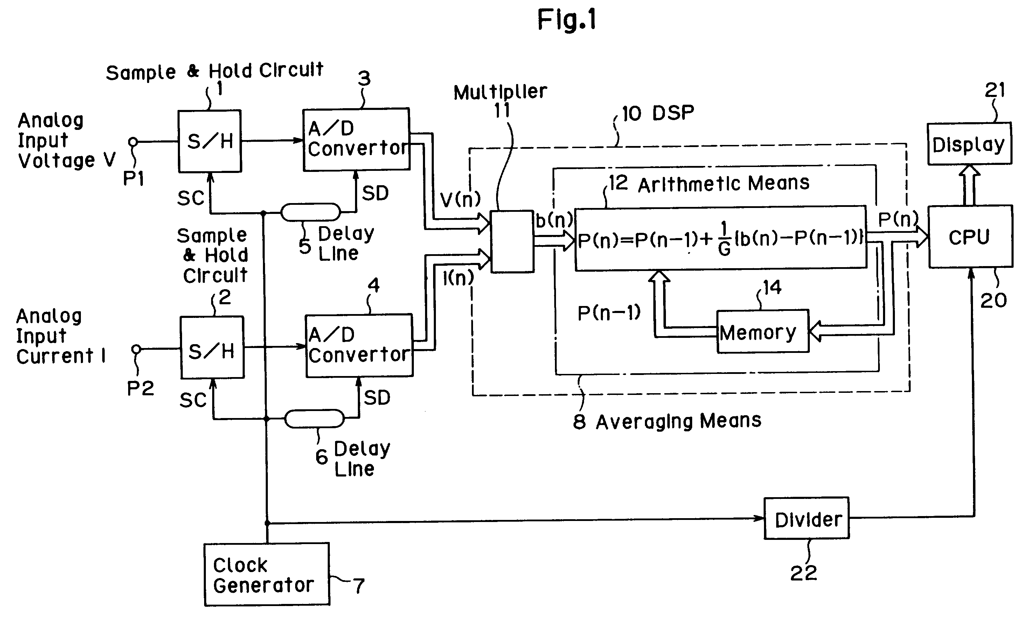

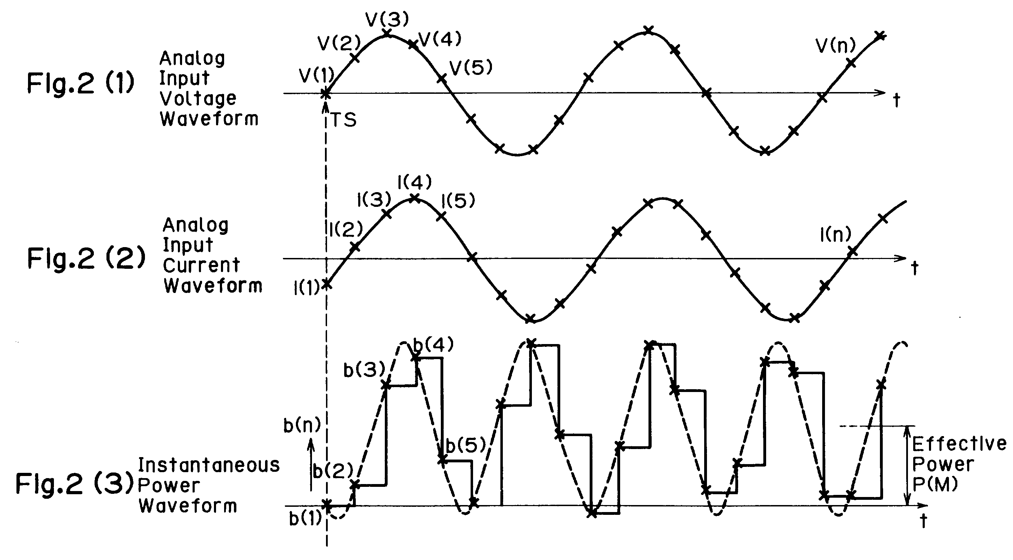

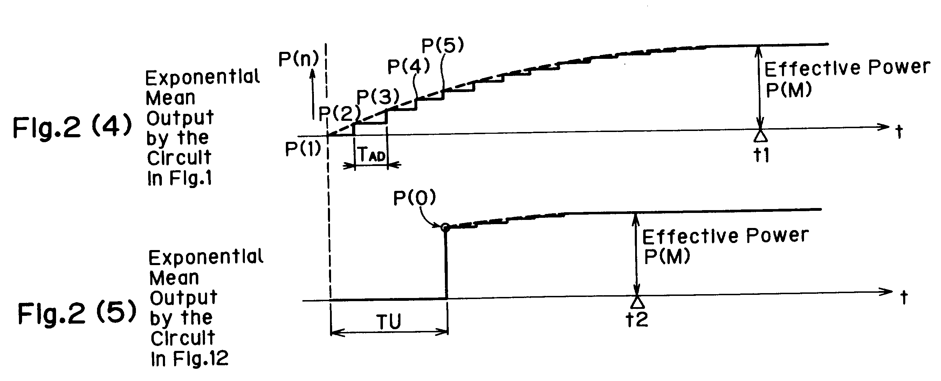

In Fig. 1, a measurement signal or analog input voltage V is applied to a terminal P1, and another measurement signal or analog input current i is applied to another terminal P2. The analog input voltage V ( see the waveform of Fig. 2(1) ) applied to the terminal P1 is sent to a sample/hold circuit ( referred to as S/H circuit ) 1.

A clock generator 7 provides a clock signal SC of certain period T_{AD} which is supplied to S/H circuits 1 and 2, delay lines 5 and 6, and frequency divider (referred hereinafter as "divider") 22. The clock generator 7 may be made of a conventional circuit including, for example, a crystal oscillator ( not shown ).

A delay line 5 functions to delay the clock signal SC and may be made of a combination of inductor and capacitor.

An S/H circuit 1 performs sampling on the analog input voltage V upon each receipt of the clock signal SC from the clock generator 7 to pick up the instantaneous value V(n) of the analog input voltage V corresponding in timing to each clock reception, and provides the just sampled value in place of the old one. In Fig. 2(1), the mark "x" indicates each sampling point.

An analog-digital ( AD ) converter ( referred to as ADC ) 3 converts the analog signal from the S/H circuit 1 into digital form. Specifically, upon receipt of a start signal SD which is the clock signal SC delayed by the delay line 5, the ADC 3 converts the signal supplied from the S/H circuit 1 into digital form. The term "analog-digital converter means" used in the Claims represents a combination of S/H circuit 1 and ADC 3.

The terminal P2 is connected to components identical in function with those connected to the terminal P1. That is, an S/H circuit 2 connected to the terminal P2 corresponds to the S/H circuit 1, an ADC 4 connected to the S/H circuit 2 corresponds to the ADC 3, and a delay line 6 corresponds to the delay line 5.

In general, the analog input current i ( see the waveform of Fig. 2(2) ) is supplied to the S/H circuit 2 after converted into a voltage signal Vi. Specifically, when the analog input current i is caused to flow through a shunt resistor ( not shown ) of known resistance RS, a voltage Vi (= RS · i) is generated. Since the resistance RS of the shunt resistor is known, measuring the analog input current is equivalent to measuring the voltage Vi in consideration of the relationship: i = Vi/RS. In this specification, the voltage signal Vi which is a transformation of the analog input current i is also referred to as the analog input current i.

The S/H circuit 2 is applied with the same clock signal SC as for the S/H circuit 1, thus performs sampling on the analog input current i at the same sampling timing as of the S/H circuit 1.

A multiplier 11 receives the value V(n) from the ADC 3 and the value i(n) from the ADC 4 ( these two values correspond to the same sampling moment or n-th sampling action ), and multiplies the two values together to provide a value b(n) (= V(n) · i(n)). The resulting product b(n) represents an instantaneous power value corresponding to the n-th sampling action. The output of the multiplier 11 is in digital form and will be plotted in the form of the solid-line waveform shown in Fig. 2(3). Since multiplication is performed on the two sampled values, the resulting product changes stepwise. The dotted-line waveform shown in Fig. 2(3) represents the ideal product of the two waveforms shown in Figs. 2(1) and (2).

An averaging means 8 receives both the instantaneous power value b(n) from the multiplier 11 and a last mean value P(n-1) calculated by itself which covers the n-1 sampling actions, and performs the calculation of Equation (2) using a preset constant 1/G to provide the new/present mean value P(n) covering the n sampling actions. The calculation of Equation (2) is referred to as exponential averaging calculation.

The averaging means 8 may be made of a combination of arithmetic means 12 and memory 14.

The arithmetic means 12 performs exponential averaging calculation on the value b(n) from the multiplier 11. Specifically, upon receipt of each value from the multiplier 11, the arithmetic means 12 performs the calculation of Equation (2). That is, the arithmetic means 12 receives the instantaneous power value b(n) corresponding to the n-th sampling action, receives from the memory 14 the last mean value P(n-1) calculated by itself which covers the n-1 sampling actions, and performs the calculation of Equation (2) using the preset constant 1/G, thereby providing the present mean value P(n) covering the n sampling actions. This new mean value P(n) is stored in the memory 14 and when the value P(n) is sufficiently stabilized, this value is also sent to a CPU 20.$\text{P(n) = P(n-1) + (1/G) · {b(n) - P(n-1)}}$ where P(n) is the exponential mean value covering the n sampling actions, P(n-1) is the exponential mean value covering the n-1 sampling actions, b(n) is the instantaneout power value corresponding to the n-th sampling action, and 1/G is the constant ( 1/G<<1 ).

Since the constant 1/G is set such that 1/G<<1, after the calculation of Equation (2) is repeated upon each application of the value b(n) to the arithmetic means 12, there is obtained the waveform shown in Fig. 2(4).

The calculation of Equation (2) means to obtain the difference between the instantaneous power value b(n) corresponding to the n-th sampling action and the last mean value P(n-1) covering the n-1 sampling actions, and to multiply the difference {b(n) - P(n-1)} by the constant 1/G. Since 1/G<<1, the calculation of (1/G) · {b(n) - P(n-1)} means to "dilute the difference" between the just sampled value and the last mean value P(n-1). The thus diluted difference is added to the last mean value P(n-1) to provide the present mean value P(n) covering the n sampling actions, and by repeating the calculation of Equation (2) a large number of times, there is obtained the mean value of the waveform under sampling.

That is, the repetition of the calculation of Equation (2) makes the value P(n) approach the mean value of the waveform of b(n). Thus, the final value of the waveform shown in Fig. 2(4) comes in accord with the mean value ( i.e. the effective power value ) of the instantaneous power waveform b(n) shown in Fig. 2(3). That is, the effective power value can be provided from the arithmetic means 12.

Since the instantaneous value ( in digital form in the embodiment ) corresponding to the sampled values is subjected directly to exponential averaging calculation, the condition that the integral multiple of one cycle Tin of the input waveform should be in accord with the integral multiple of the sampling period T_{AD} is not required; thus, the problem in the prior art can be solved.

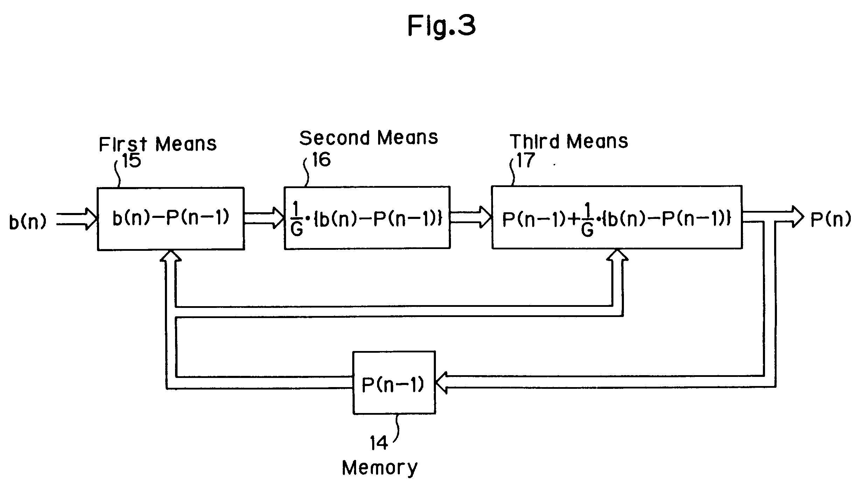

Fig. 3 shows an embodiment of the averaging means 8. Since the averaging means 8 handles digital calculation, it includes three arithmetic blocks or means.

A first means 15 receives from the memory 14 ( also shown in Fig. 1 ) the last mean value P(n-1) covering the n-1 sampling actions, receives from the multiplier 11 the instantaneous power value b(n) corresponding to the n-th sampling action, and calculates the difference {b(n) - P(n-1)} between the two received values.

A second means 16 multiplies the output {b(n) - P(n-1)} of the first means 15 by the constant 1/G to provide the value (1/G) · {b(n) - P(n-1)}. The value of the constant 1/G is previously set by, for example, the user of the device of Fig. 1.

A third means 17 calculates the sum P(n) (= P(n-1) + (1/G) {b(n) - P(n-1)}) of the last mean value P(n-1) supplied from the memory 14 and the output of the second means 16, and stores the thus calculated, present mean value P(n) in the memory 14. That is, the third means 16 provides the present mean value P(n) as expressed by Equation (2) which covers the n sampling actions.

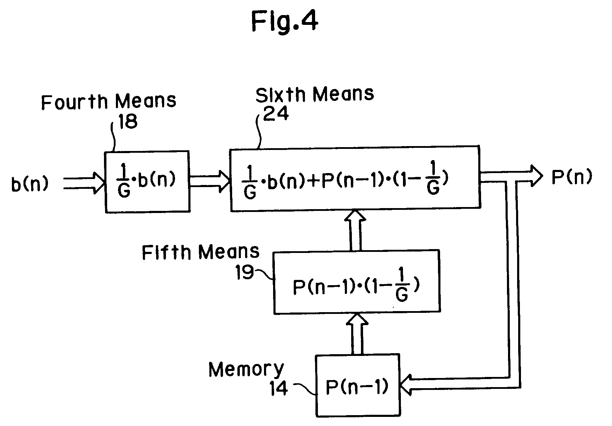

Fig. 4 shows another embodiment of the averaging means 8. Equation (2) can be rewritten into the form of Equation (3). The configuration of Fig. 4 is made in compliance with Equation (3).

A fourth means 18 receives from the multiplier 11 the instantaneous power value b(n) corresponding to the n-th sampling action, and multiplies it by the constant 1/G.

A fifth means 19 receives from the memory 14 the last mean value P(n-1) and multiplies it by a factor of ( 1 - 1/G ).

A sixth means 24 adds the output values of the fourth means 18 and the fifth means 19 together to provide the sum, (1/G) · b(n) + P(n-1) · ( 1 - 1/G ).$\text{P(n) = (1/G) · b(n) + P(n-1) · ( 1 - 1/G )}$

The foregoing functions of the multiplier 11 and the arithmetic means 12 can be attained by the use of, for example, a digital signal processor.

A central processing unit ( referred to as CPU ) 20 receives the output value P(n) of the arithmetic means 12 and after calculation is repeated a given number of times or the value P(n) comes to the so-called steady state, causes a display unit 21 to display the value ( effective power value ) P(n). The waveform of Fig. 2(4) represents the output value P(n) of the arithmetic means 12 in analog form. It should be noted that the number of times of calculation is in accord with the number of times of application of the clock signal ( the number of sampling actions ).

A divider 22 receives the clock signal SC from the clock generator 7, and after a given number of clock pulses are received, sends a signal to the CPU 20 to notify that a given number of times of calculation have been performed.

The display unit 21 displays the effective power value P(n) under the control of the CPU 20.

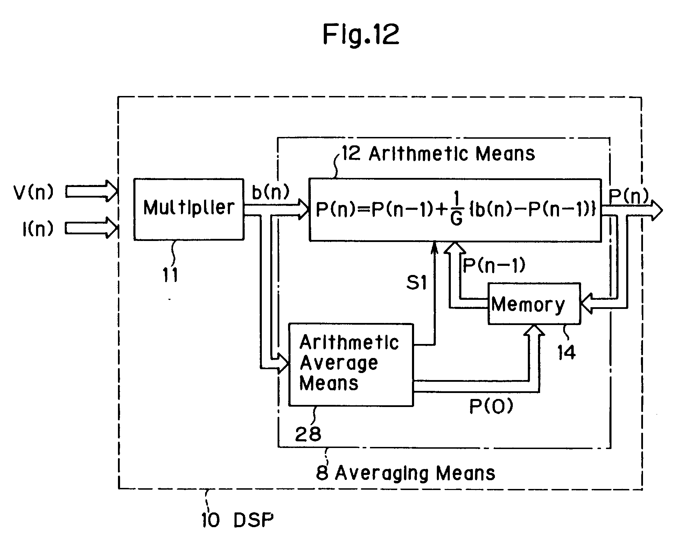

The operation of the device shown in Fig. 1 will be described with reference to Fig. 2. Fig. 2(1) shows the waveform of the analog input voltage V, Fig. 2(2) shows the waveform of the analog input current i, Fig. 2(3) shows the waveform in analog form of the instantaneous power value b(n), Fig. 2(4) shows the waveform in analog form of the exponential mean value P(n) provided from the averaging means 8, and Fig. 2(5) shows the waveform of the exponential mean value P(n) provided from a different averaging means as shown in Fig. 12.

In Fig. 1, assume that at moment TS ( see Fig. 2(1) ), the analog input voltage waveform and the analog input current waveform with a phase difference therebetween as shown in Figs. 2(1) and (2) are applied to the terminals P1 and P2, respectively.

Since the clock signal Sc of period T_{AD} is applied from the clock generator 7 to the two S/H circuits 1 and 2, the sampling action is performed at the same timing; consequently, values V(1), V(2), V(3),..., i(1), i(2), i(3),... are picked up at points of mark "x" shown in Figs. 2(1) and (2), and successively converted in the ADC's 3 and 4 into digital form.

Since the delay lines 5 and 6 delay the clock signal SC a little while, the ADC's 3 and 4 can receive the values from the S/H circuits 1 and 2 kept in a stable hold state.

The ADC 3 provides the digital values V(n) corresponding to the sampled values V(1), V(2), V(3),... shown in Fig. 2(1), and the ADC 4 provides the digital values i(n) corresponding to the sampled values i(1), i(2), i(3),... shown in Fig. 2(2) ( n = 1, 2, 3,... ).

The multiplier 11 multiplies the two values picked up at the same sampling timing together to provide the instantaneous power value b(n) (= V(n) · i(n)). The solid-line stepwise waveform shown in Fig. 2(3) represents the thus obtained instantaneous power value b(n) in analog form.

The arithmetic means 12 receives the value b(n) shown in Fig. 2(3) and performs the calculation of either Equation (2) or Equation (3). The thus obtained exponential mean value P(n) is plotted in Fig. 2(4). The finally converged value of the mean value P(n) represents the effective power value ( also referred to as the mean power value ).

Although Fig. 2(4) shows the curve of the exponential mean value P(n) as if it take a fixed value within an interval of time corresponding to a small number of times of sampling ( calculation ), in actual operation, about 1000 times of calculation are normally needed before the value becomes fixed.

After a given number of ( for example, 1000 ) times of calculation are performed, the divider 22 sends a signal to the CPU 20; consequently, the CPU reads the present mean value P(n) and causes the display unit 21 to display the effective power value.

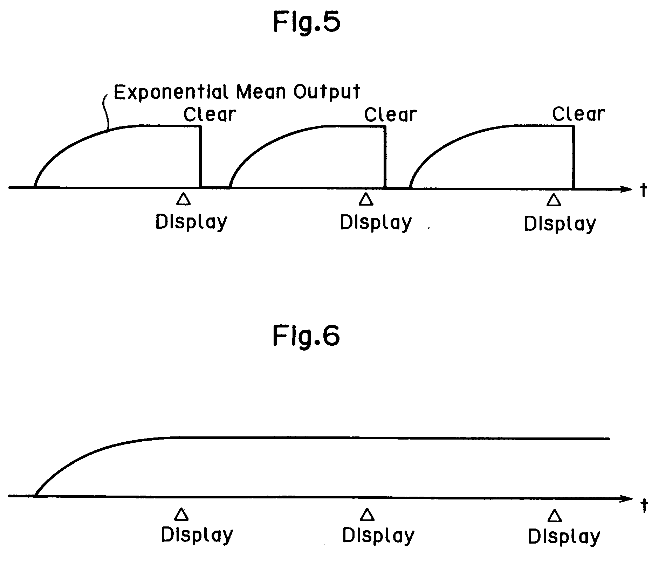

The sampling type measuring device according to the present invention will take either of two display methods as shown in Figs. 5 and 6.

According to the display method shown in Fig. 5, at each point of mark "△" where the mean value P(n) reaches the final value or comes close thereto, the value at that point is displayed ( the display of the display unit 21 is renewed ), the content of the memory 14 is cleared ( the value P(n-1) is set to zero ), and calculation is restarted with the value = zero.

According to the display method shown in Fig. 6, without clearing the content of the memory 14, the present mean value P(n) is displayed every time when a given number of times of calculation have been reached.

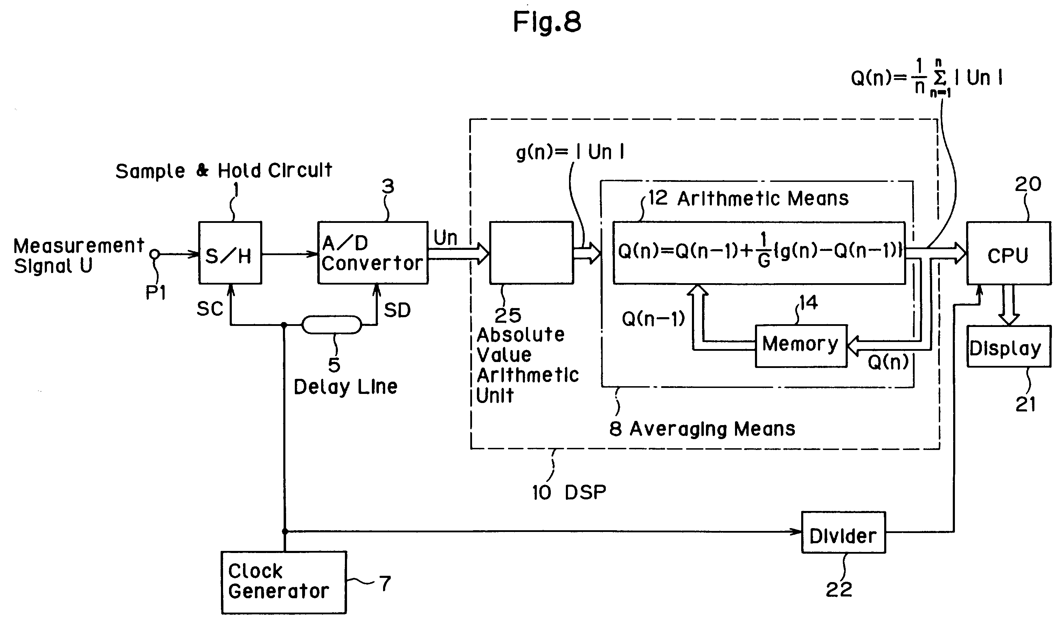

Fig. 8 shows another embodiment of the sampling type measuring device according to the present invention which is embodied in the form of a mean value rectifying type measuring device. The mean value rectifying type measuring device is designed to rectify an a.c. signal in a full-wave or half-wave rectification mode and calculate the mean value of the resulting waveform. The device shown in Fig. 8 is designed to rectify an a.c. signal in the full-wave rectification mode and calculate the mean value of the resulting waveform.

The S/H circuit 1, ADC 3, delay line 5, clock generator 7, averaging means 8, CPU 20, display unit 21, and divider 22 shown in Fig. 8 are identical in function with those shown in Fig. 1 which bear the same reference numerals. The configuration of Fig. 8 differs from the configuration of Fig. 1 in that the configuration of Fig. 8 includes no components corresponding to the S/H circuit 2, ADC 4, and delay line 6 included in the configuration of Fig. 1, and that the configuration of Fig. 8 includes an absolute value arithmetic unit 25 in place of the multiplier 11 included in the configuration of Fig. 1.

The mutual connection between the S/H circuit 1, ADC 3, delay line 5, and clock generator 7 in Fig. 8 is identical with that of Fig. 1.

Upon receipt of the clock signal SC, the S/H circuit 1 performs sampling on a measurement signal U at the timing defined by the clock signal. The measurement signal U may be in the form of an analog input voltage signal or an analog input current signal. Upon each receipt of the signal SD passed through the delay line 5, the ADC 3 converts a signal sampled by the S/H circuit 1 into a digital value Un. That is, the digital value Un represents the instantaneous value of the measurement signal U.

The absolute value arithmetic unit 25 receives the value Un from the ADC 3 and provides the absolute value g(n) (= |Un|) of the value Un. Since the output Un of the ADC 3 is in digital form, the absolute value arithmetic unit 25 provides the amplitude value in digital form of the value Un. The absolute value g(n) (= |Un|) which is the output of the absolute value arithmetic unit 25 represents the instantaneous value in digital form of the waveform obtained by rectifying the measurement signal U in the full-wave rectification mode.

The averaging means 8 shown in Fig. 8 is identical in configuration and function with the averaging means 8 shown in Fig. 1, and performs the calculation of Equation (4). Specifically, the averaging means in Fig. 8 receives from the absolute value arithmetic unit 25 the absolute value g(n) corresponding to the instantaneous value, receives a last mean value Q(n-1) calculated by itself which covers the n-1 sampling actions, and performs the calculation of Equation (4) using a preset constant 1/G, thereby providing a present mean value Q(n) covering the n sampling actions.$\text{Q(n) = Q(n-1) + (1/G)·{g(n) - Q(n-1)}}$ where Q(n) is the exponential mean value covering the n sampling actions, Q(n-1) is the exponential mean value covering the n-1 sampling actions, g(n) is the absolute value corresponding to the n-th sampling action, and 1/G is the constant ( 1/G<<1 ).

Equation (4) is analogous to Equation (2). That is, the Q(n) in Equation (4) corresponds to the P(n) in Equation (2), the Q(n-1) to the P(n-1), the g(n) to the b(n), and the 1/G to the 1/G. Therefore, the averaging means 8 in Fig. 8 provides the exponential mean value of the absolute value g(n) (= |Un|) of the measurement signal, which is obtained by subjecting the measurement signal U to mean value rectification.

The averaging means 8 in Fig. 8 may be made of a combination of arithmetic means 12 and memory 14 as is the case of Fig. 1. Further, the averaging means 8 in Fig. 8 may take the configuration shown in Fig. 3 or Fig. 4 as is the case of the averaging means 8 of Fig. 1.

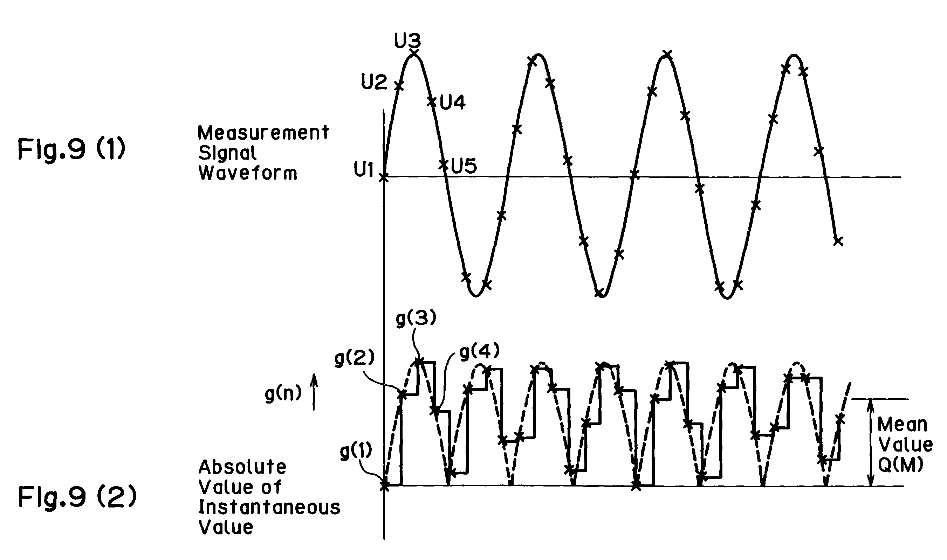

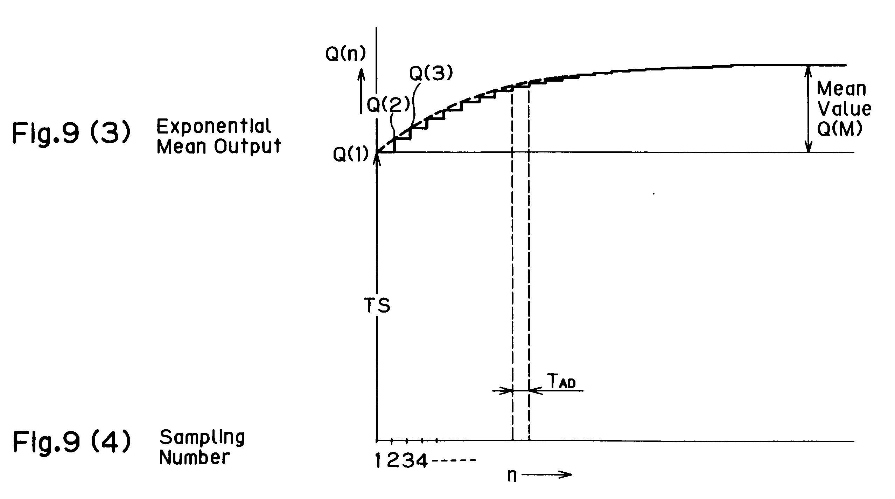

The CPU 20 receives the output Q(n) of the arithmetic means 12, and after a given number of times of calculation are performed, causes the display unit 21 to display the value Q(n) having come to the steady state as shown in Fig. 9(3). It should be noted that the number of times of calculation is in accord with the number of pulses of the clock signal ( the number of times of sampling ). The divider 22 receives the clock signal SC from the clock generator 7, and after a given number of clock pulses are received, sends a signal to the CPU 20 to notify that a given number of times of calculation have been performed.

The display unit 21 displays the mean value Q(n) of rectification of the measurement signal U under the control of the CPU 20.

The operation of the device of Fig. 8 will be described with reference to Fig. 9. Fig. 9(1) shows the waveform, of the measurement signal U, Fig. 9(2) shows the waveform in analog form of the absolute value g(n) of the sampled value, Fig. 9(3) shows the waveform in analog form of the exponential mean value Q(n) provided from the averaging means 8, and Fig. 9(4) shows the number of times of sampling.

In Fig. 8, assume that at moment TS ( see Fig. 9(3) ), the waveform of the measurement signal U as shown in Fig. 9(1) is applied to the terminal P1.

Upon each receipt of the clock signal SC of period T_{AD} from the clock generator 7, the S/H circuit 1 performs sampling to send the value sampled at each point of mark "x" shown in Fig. 9(1) to the ADC 3. The ADC 3 converts each received value into digital values U1, U2, U3,.... Un ( see Fig. 9(1) ).

The absolute value arithmetic unit 25 provides the absolute value g(n) (= |Un|) of the instantaneous value Un received. That is, the absolute value arithmetic unit 25 provides the digital amplitude value of the value Un. The solid-line stepwise waveform of Fig. 9(2) shows the thus obtained absolute value g(n) in analog form. The broken-line waveform of Fig. 9(2) shows the ideal full-wave-rectified waveform of the waveform of Fig. 9(1).

The arithmetic means 12 receives the value g(n) of Fig. 9(2) and performs the calculation of Equation (4). The thus obtained exponential mean value Q(n) is plotted in Fig. 9(3). The finally converged value Q(M) of the mean value Q(n) represents the mean value of the rectified waveform of the measurement signal U.

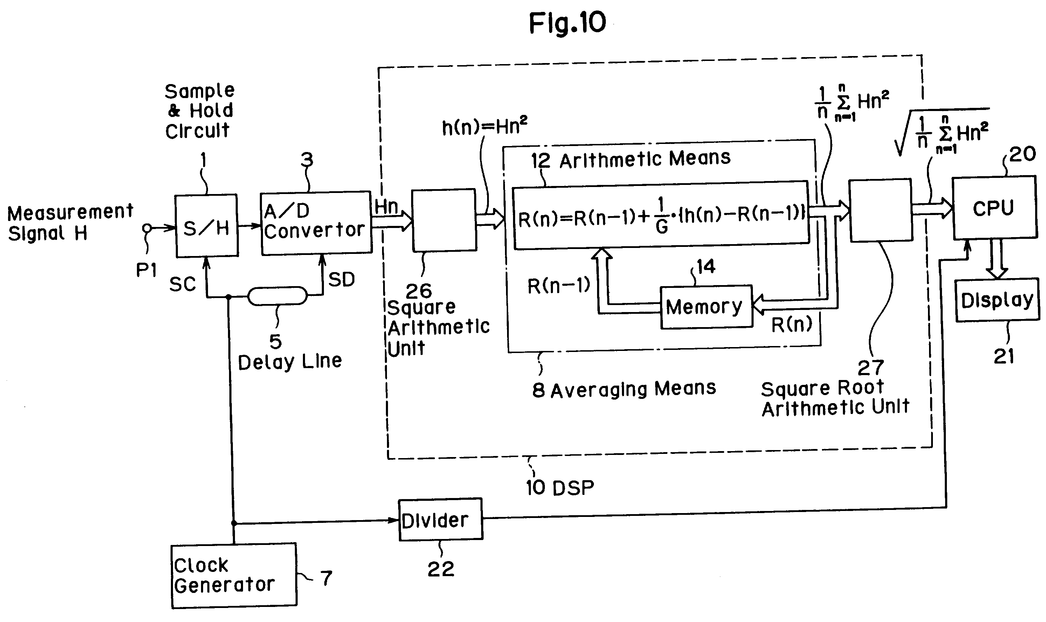

Fig. 10 shows still another embodiment of the sampling type measuring device according to the present invention which is embodied in the form of an effective value measuring device.

The S/H circuit 1, ADC 3, delay line 5, clock generator 7, averaging means 8, CPU 20, display unit 21, and divider 22 shown in Fig. 10 are identical in function with those shown in Fig. 1 which bear the same reference numerals. The configuration of Fig. 10 differs from the configuration of Fig. 1 in that the configuration of Fig. 10 includes no components corresponding to the S/H circuit 2, ADC 4, and delay line 6 included in the configuration of Fig. 1, that the configuration of Fig. 10 includes a square arithmetic unit 26 in place of the multiplier 11 included in the configuration of Fig. 1, and that the configuration of Fig. 10 additionally includes a square root arithmetic unit 27 which receives the output of the averaging means 8 and performs square root calculation thereon.

The mutual connection between the S/H circuit 1, ADC 3, delay line 5, and clock generator 7 in Fig. 10 is identical with that of Fig. 1.

Upon receipt of the clock signal SC, the S/H circuit 1 performs sampling on a measurement signal H at the timing defined by the clock signal to pick up an instantaneous value. The measurement signal H may be in the form of an analog input voltage signal or an analog input current signal. Upon each receipt of the signal SD passed through the delay line 5, the ADC 3 converts the instantaneous value sampled by the S/H circuit 1 into a digital value Hn.

The square arithmetic unit 26 receives the value Hn from the ADC 3 and provides the square value h(n) (= H$\frac{\text{2}}{\text{n}}$) of the value Hn. That is, the square value of the instantaneous value Hn corresponding to the n-th sampling action is provided from the ssquare arithmetic unit 26.

The averaging means shown in Fig. 10 is identical in configuration and function with the averaging means 8 shown in Fig. 1, and performs the calculation of Equation (5). Specifically, the averaging means 8 receives the square value h(n) from the square arithmetic unit 26, receives a last mean value R(n-1) calculated by itself which covers the n-1 sampling actions, and performs the calculation of Equation (5) using a preset constant 1/G, thereby providing a present mean value R(n) covering the n sampling actions.$\text{R(n) = R(n-1) + (1/G) · {h(n) - R(n-1)}}$ where R(n) is the exponential mean value covering the n sampling actions, R(n-1) is the exponential mean value covering the n-1 sampling actions, h(n) is the absolute value corresponding to the n-th sampling action, and 1/G is the constant (1/G << 1).

Equation (5) is analogous to Equation (2). That is, the R(n) in Equation (5) corresponds to the P(n) in Equation (2), the R(n-1) to the P(n-1), the h(n) to the b(n), and the 1/G to the 1/G. Therefore, the averaging means 8 in Fig. 10 provides the mean value, 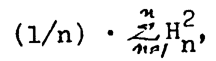 of the square value h(n) (= H$\frac{\text{2}}{\text{n}}$) of the measurement signal H.

The averaging means 8 in Fig. 10 may be made of a combination of arithmetic means 12 and memory 14 as is the case of Fig. 1. Further, the averaging means 8 in Fig. 10 may take the configuration shown in Fig. 3 or Fig. 4 as is the case of the averaging means 8 of Fig. 1.

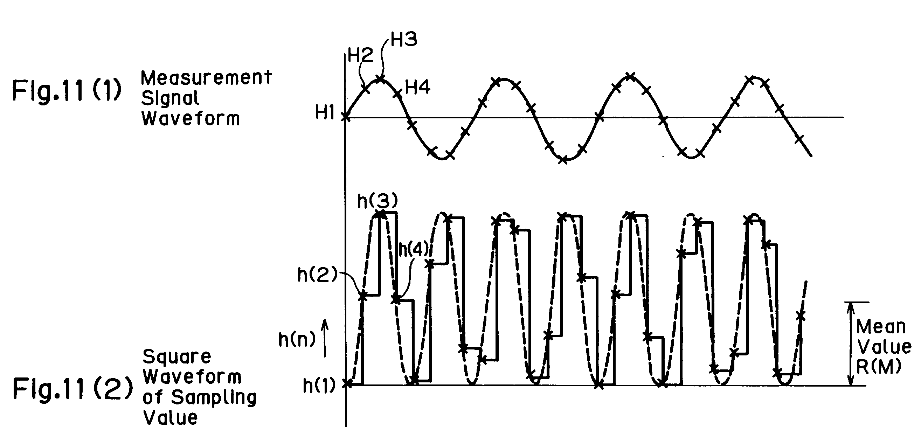

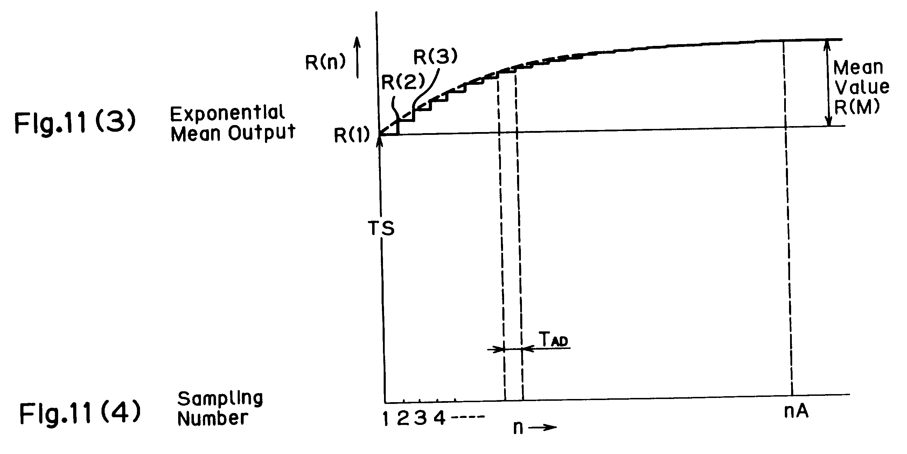

The square root arithmetic unit 27 receives the value 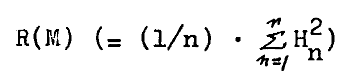 which finally becomes fixed after a given number of times of calculation are performed in the averaging means 8 ( see Fig. 11(4), "nA" ), and calculates the square root of the value R(M), thereby providing the effective value 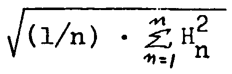 of the measurement signal H. The square root arithmetic unit 27 for obtaining the square root of a received signal is well known in the art, thus its detailed configuration is not described herein.

The CPU 20 receives the value 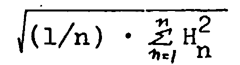 from the square root arithmetic unit 27 and causes the display unit 21 to display it. That is, the display unit 21 displays the effective value 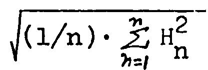 of the measurement signal H under the control of the CPU 20.

The operation of the device of Fig. 10 will be described with reference to Fig. 11. Fig. 11(1) shows the waveform of the measurement signal H, Fig. 11(2) shows the waveform in analog form of the square value h(n) of the sampled value ( the instantaneous value ) shown in Fig. 11(1), Fig. 11(3) shows the waveform in analog form of the exponential mean value R(n) provided from the averaging means 8, and Fig. 11(4) shows the number of times of sampling.

In Fig. 10, assume that at moment TS ( see Fig. 11(3) ), the waveform of the measurement signal H as shown in Fig. 11(1) is applied to the terminal P1.

Upon each receipt of the clock signal SC of period T_{AD} from the clock generator 7, the S/H circuit 1 performs sampling to send the value picked up at each point of mark "x" shown in Fig. 11(1) to the ADC 3. The ADC 3 converts each received value into digital values H1, H2, H3,..., Hn ( see Fig. 11(1) ).

The square arithmetic unit 26 provides the square value h(n) (= H$\frac{\text{2}}{\text{n}}$) of the digital value Hn. The solid-line stepwise waveform of Fig. 11(2) shows the thus obtained square value h(n) in analog form. The reason why the waveform is stepwise is because the waveform is based on the sampled value. The broken-line waveform of Fig. 11(2) shows an ideal square waveform corresponding to the waveform of Fig. 11(1).

The arithmetic means 12 receives the value h(n) of Fig. 11(2) and performs the calculation of Equation (5). The thus obtained exponential mean value R(n) is plotted in Fig. 11(3). The finally converged value R(n) ( for example, the mean value corresponding to the nA-th sampling action, see Fig. 11(4) ) is sent to the square root arithmetic unit 27, in which the square root of the mean value is calculated, so that the effective value 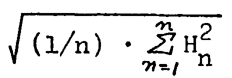 of the measurement signal H is provided.

Fig. 12 shows still another embodiment of the averaging means usable in the sampling type measuring device of the present invention. The averaging means shown in Fig. 12 is capable of enhancing responsibility in obtaining the exponential mean value. The averaging means of Fig. 12 is designed for use in the sampling type wattmeter of Fig. 1. Therefore, the signals V(n) and i(n) shown in Fig. 12 are those being applied to the ADC's 3 and 4 shown in Fig. 1, and the value P(n) shown in Fig. 12 is that being applied to the CPU 20 shown in Fig. 1.

The averaging means 8 of Fig. 12 differs from the averaging means 8 of Fig. 1 in that there is additionally included an arithmetic averaging means 28. The other configuration of Fig. 12 is identical with that of Fig. 1.

The arithmetic averaging means 28 functions to obtain the arithmetic mean value of a given number of values provided from the multiplier 11. For example, when the multiplier 11 provides the values b(1), b(2), ..., b(k), and the number of values, k ( which is usually a small number, e.g. 20 ), the following calculation is performed:$\text{P(0) = {b(1)+b(2)+b(3)+ ..... b(k)}/k}$

The result of calculation, P(0), is stored in the memory 14 as the initial value of Equation (2). In this case, it makes no matter whether the fraction TY shown in Fig. 7 takes an appreciable width or not. The reason is that setting the initial value P(0) to a round value makes no matter. When the initial value P(0) is obtained, together with it, a signal S1 notifying the delivery of the initial value P(0) is sent to the arithmetic means 12.

The operation of the sampling type measuring device including the averaging means 8 of Fig. 12 will be described with reference to Fig. 2. At moment TS, the analog input voltage waveform and the analog input current waveform with a phase difference therebetween as shown in Figs. 2(1) and (2) are applied to the terminals P1 and P2, respectively. On the other hand, the clock signal SC is applied from the clock generator 7 to the S/H circuits 1 and 2, so that sampling is performed concurrently in these circuits. The resulting sampled values are converted in the ADC's 3 and 4 into digital form, thereby providing the instantaneous digital voltage value V(n) and instantaneous digital current value i(n) of the same timing.

The multiplier 11 multiplies these two values together to provide the instantaneous power value b(n) ( see Fig. 2(3) ). Specifically, the multiplier 11 provides the instantaneous power values b(1), b(2), b(3), .... in succession in synchronization with the clock signal SC.

The arithmetic averaging means 28 has a number "k" set therein, decrements the number k by one upon each receipt of the values b(1), b(2), b(3), .... from the multiplier 11, and when k = 0 is reached, performs the calculation of Equation (6). That is, the arithmetic averaging means provides the initial value P(0) which is the arithmetic mean value of the k values, and stores it in the memory 14. Further, the arithmetic averaging means 28 sends the signal S1 notifying the delivery of the initial value P(0) to the arithmetic means 12. It should be noted that the time TU shown in Fig. 2(5) indicates an interval of time until the value P(0) of Equation (6) is calculated.

In the example of Fig. 2(5), the initial value P(0) is the arithmetic mean value of the four instantaneous power values b(1), b(2), b(3) and b(4) shown in Fig. 2(3). As will be appreciated from the comparison between Fig. 2(4) and Fig. 2(5), the rising speed of the value P(0) obtained by arithmetic averaging ( see Fig. 2(5) ) is much faster than that of the curve ( see Fig. 2(4) ) obtained by exponential averaging based on Equation (2).

That is, in the case of the device shown in Fig. 1, calculation is started with the initial value P(0) = 0, and the difference between the last mean value P(n-1) and the present sampled value b(n) is "diluted" by the use of the constant 1/G (1/G << 1); therefore, the grade in variation of the curve of Fig. 2(4) is small. Contrarily, in the case of the device shown in Fig. 12, calculation is started with the initial value P(0) equal to the foregoing arithmetic mean value P(0); therefore, the rising speed is quick.

The arithmetic means 12 in the averaging means 8 of Fig. 12 performs no calculation or is quiescent during the interval TU shown in Fig. 2(5). Upon receipt of the signal S1 from the arithmetic averaging means 28, the arithmetic means 12 begins exponential averaging calculation in accordance with Equation (2). In this case, "P(n-1) = P(0)" is adopted at the first calculation step of Equation (2). In the example of Fig. 2(5), the first calculation operation of the arithmetic means 12 handles the 5th sampling action as follows:$\text{P(5) = P(0) + (1/G) · {b(5) - P(0)}}$

Subsequently, the calculation of Equation (2) is performed upon each delivery of the value from the multiplier 11; therefore, as shown in Fig. 2(5), the effective power value can be converged faster than in the response waveform of Fig. 2(4).

The effects of the present invention are as follows:
(1) Since measurement can be performed irrespective of whether or not one cycle of the input waveform is in accord with the integral multiple of the sampling period, no circuit is needed for measuring one cycle of the input waveform. Further, no means is needed for controlling the sampling period as to correspond to an integral fraction of one cycle of the input waveform. Therefore, cost reduction can be attained.
(2) Since it is not necessary to continue sampling and calculating until the integral multiple of one cycle Tin of the input waveform comes into accord with the integral multiple of the sampling period T_{AD}, the response time of measurement never elongates.
(3) Since it is not necessary to shorten the sampling period, costly ADC's are not required.
(4) Since the present mean value P(n) covering the n sampling actions is calculated on the basis of the last mean value P(n-1) covering the n-1 sampling actions ( see Equation (2) ), or since the present invention is not of the addition system ( see Equation (1) ), the object mean value can be renewed comparatively quickly in conformity with the change in magnitude of the measurement signal.

## Claims

1. A sampling type measuring device for measuring an analog input signal by performing sampling on the analog input signal at a certain period, converting each value picked up by sampling into digital form, and processing the digital values, which comprises
first analog-digital converter means (3) for performing sampling on an analog input voltage and converting each value picked up by sampling into digital form,
second analog-digital converter means (4) for performing sampling on an analog input current at the same timing with the sampling action of the first analog-digital converter means (3) and converting each value picked up by sampling into digital form,
a multiplier (11) for multiplying the output value of the first analog-digital converter means (3) and the corresponding output value of the second analog-digital converter means (4) together to provide an instantaneous power value b(n), where the power value b(n) corresponds to the n-th sampling action, and
averaging means (8) for receiving the instantaneous power value b(n) and a last mean value P(n-1) calculated by itself which covers the n-1 sampling actions and performing the calculation of the following equation:$\text{P(n) = P(n-1) + (1/G) · {b(n) - P(n-1)}}$ on the two received values using a preset constant 1/G, where 1/G<<1, to provide a present mean value P(n) covering the n sampling actions.

2. A sampling type measuring device according to claim 1, wherein the averaging means is composed of
first means (15) for receiving the last mean value P(n-1) from memory means (14) and the present instantaneous power value b(n) from the multiplier (11) and calculating the difference, b(n) - P(n-1), between the two received values,
second means (16) for multiplying the output value, b(n) - P(n-1), of the first means (15) by the constant 1/G, and
third means (17) for calculating the sum, P(n) = P(n-1) + (1/G) · {b(n) - P(n-1)}, of the last mean value P(n-1) from the memory means (14) and the output value of the second means (16) and storing the present mean value P(n) in the memory means (14).

3. A sampling type measuring device for measuring an analog input signal by performing sampling on the analog input signal at a certain period, converting each value picked up by sampling into digital form, and processing the digital values, which comprises
analog-digital converter means (3) for performing sampling on an analog input signal and converting each value picked up by sampling into digital form,
an absolute value arithmetic unit (25) for obtaining the absolute value g(n) of the output value of the analog-digital converter means (3), where the absolute value g(n) corresponds to the n-th sampling action, and
averaging means (8) for receiving the present absolute value g(n) and a last mean value Q(n-1) calculated by itself which covers the n-1 sampling actions and performing the calculation of the following equation:$\text{Q(n) = Q(n-1) + (1/G) · {g(n) - Q(n-1)}}$ on the two received values using a preset constant 1/G, where 1/G << 1, to provide a present mean value Q(n) covering the n sampling actions.

4. A sampling type measuring device for measuring an analog input signal by performing sampling on the analog input signal at a certain period, converting each value picked up by sampling into digital form, and processing the digital values, which comprises
analog-digital converter means (3) for performing sampling on an analog input signal and converting each value picked up by sampling into digital form,
a square arithmetic unit (26) for performing square calculation on the output value of the analog-digital converter means (3) to provide a square value h(n), where the square value h(n) corresponds to the n-th sampling action,
averaging means (8) for receiving the square value h(n) and a last mean value R(n-1) covering the n-1 sampling actions and performing the calculation of the following equation:$\text{R(n) = R(n-1) + (1/G) · {h(n) - R(n-1)}}$ on the two received values using a preset constant l/G, where 1/G << 1, to provide a present mean value R(n) covering the n sampling actions, and
a square root arithmetic unit (27) for performing square root calculation on the output value of the averaging means (8).

## Patentansprüche

1. Abtastmeßvorrichtung zum Messen eines analogen Eingangssignals mittels einer Abtastung des analogen Eingangssignals mit einer bestimmten Periode, Umwandeln jeder durch Abtastung abgegriffenen Größe in eine digitale Form und Verarbeiten der digitalen Größen, umfassend:
eine erste Analog/Digital-Wandlereinrichtung (3) zum Durchführen einer Abtastung einer analogen Eingangsspannung und zum Umwandeln jeder durch Abtastung abgegriffenen Größe in eine digitale Form,
eine zweite Analog/Digital-Wandlereinrichtung (4) zum Durchführen einer Abtastung eines analogen Eingangsstroms im gleichen Zeittakt (timing) mit dem Abtastvorgang der ersten Analog/Digital-Wandlereinrichtung (3) und zum Umwandeln jeder durch Abtastung abgegriffenen Größe in eine digitale Form,
eine Multiplizierstufe (11) zum Multiplizieren der Ausgangsgröße der ersten Analog/Digital-Wandlereinrichtung (3) mit der entsprechenden Ausgangsgröße der zweiten Analog/Digital-Wandlereinrichtung (4) zwecks Lieferung einer Momentanleistungsgröße b(n), wobei die Leistungsgröße b(n) dem n-ten Abtastvorgang entspricht, und
eine Mittelwert(bildungs)einrichtung (8) zum Empfangen bzw. Abnehmen der Momentanleistungsgröße b(n) und eines letzten, selbst berechneten Mittelwerts P(n-1), welcher die n-1 Abtastvorgänge abdeckt bzw. umfaßt, und zum Durchführen der Berechnung folgender Gleichung:$\text{P(n) = P(n-1) + (1/G) · {b(n) - P(n-1)}}$ mit den beiden abgenommenen Größen unter Heranziehung einer vorgegebenen Konstante 1/G, mit 1/G << 1, zwecks Lieferung eines aktuellen Mittelwerts P(n), der die n Abtastvorgänge umfaßt.

2. Abtastmeßvorrichtung nach Anspruch 1, wobei die Mittelwerteinrichtung folgendes umfaßt:
eine erste Einrichtung (15) zum Abnehmen des letzten Mittelwerts P(n-1) von einer Speichereinrichtung (14) und der aktuellen Momentanleistungsgröße b(n) von der Multiplizierstufe (11) und zum Berechnen der Differenz b(n) - P(n-1) zwischen den beiden abgenommenen Größen,
eine zweite Einrichtung (16) zum Multiplizieren der Ausgangsgröße b(n) - P(n-1) von der ersten Einrichtung (15) mit der Konstante 1/G und
eine dritte Einrichtung (17) zum Berechnen der Summe P(n) = P(n-1) + (1/G) · {b(n) - P(n-1)} aus dem letzten Mittelwert P(n-1) von der Speichereinrichtung (14) und der Ausgangsgröße der zweiten Einrichtung (16) und zum Speichern oder Ablegen des aktuellen Mittelwerts P(n) in der Speichereinrichtung (14).

3. Abtastmeßvorrichtung zum Messen eines analogen Eingangssignals mittels einer Abtastung des analogen Eingangssignals mit einer bestimmten Periode, Umwandeln jeder durch Abtastung abgegriffenen Größe in eine digitale Form und Verarbeiten der digitalen Größen, umfassend:
eine Analog/Digital-Wandlereinrichtung (3) zum Durchführen einer Abtastung eines analogen Eingangssignals und zum Umwandeln jeder durch Abtastung abgegriffenen Größe in eine digitale Form,
eine Absolutwertrecheneinheit (25) zum Gewinnen des Absolutwerts g(n) der Ausgangsgröße von der Analog/Digital-Wandlereinrichtung (3), wobei der Absolutwert g(n) dem n-ten Abtastvorgang entspricht, und
eine Mittelwert (bildungs) einrichtung (8) zum Abnehmen des aktuellen Absolutwerts g(n) und eines letzten, selbst berechneten, die n-t Abtastvorgänge umfassenden Mittelwerts Q(n-1) und zum Durchführen der Berechnung folgender Gleichung:$\text{Q(n) = Q(n-1) + (1/G) · {g(n) - Q(n-1)}}$ mit den beiden abgenommenen Größen unter Heranziehung einer vorgegebenen Konstante 1/G, mit 1/G << 1, zwecks Lieferung eines aktuellen Mittelwerts Q(n), der die n Abtastvorgänge umfaßt.

4. Abtastmeßvorrichtung zum Messen eines analogen Eingangssignals mittels einer Abtastung des analogen Eingangssignals mit einer bestimmten Periode, Umwandeln jeder durch Abtastung abgegriffenen Größe in eine digitale Form und Verarbeiten der digitalen Größen, umfassend:
eine Analog/Digital-Wandlereinrichtung (3) zum Durchführen einer Abtastung eines analogen Eingangssignals und zum Umwandeln jeder durch Abtastung abgegriffenen Größe in eine digitale Form,
eine Quadratrecheneinheit (26) zur Durchführung einer Quadratberechnung der Ausgangsgröße der Analog/Digital-Wandlereinrichtung (3) zwecks Lieferung eines Quadrats bzw. einer Quadratgröße h(n), welche dem n-ten Abtastvorgang entspricht,
eine Mittelwert(bildungs)einrichtung (8) zum Abnehmen der Quadratgröße h(n) und eines letzten, die n-1 Abtastvorgänge umfassenden Mittelwerts R(n-1) und zum Durchführen des Berechnens der folgenden Gleichung:$\text{R(n) = R(n-1) + (1/G) · {h(n) - R(n-1)}}$ mit den beiden abgenommenen Größen unter Heranziehung einer vorgegebenen Konstante 1/G, mit 1/G << 1, zur Lieferung eines aktuellen Mittelwerts (R(n), der die n Abtastvorgänge umfaßt, und
eine Quadratwurzelrecheneinheit (27) zur Durchführung einer Quadratwurzelberechnung an der Ausgangsgröße der Mittelwerteinrichtung (8).

## Revendications

1. Dispositif de mesure du type à échantillonnage pour mesurer un signal d'entrée analogique en réalisant un échantillonnage du signal d'entrée analogique à une certaine période, une conversion sous forme numérique de chaque valeur prélevée par échantillonnage, et un traitement des valeurs numériques, qui comprend :
un premier moyen convertisseur analogique/numérique (3) pour réaliser un échantillonnage d'une tension d'entrée analogique et une conversion sous forme numérique de chaque valeur prélevée par échantillonnage,
un second moyen convertisseur analogique/numérique (4) pour réaliser un échantillonnage d'un courant d'entrée analogique au même instant que l'action d'échantillonnage du premier moyen convertisseur analogique/numérique (3) et une conversion sous forme numérique de chaque valeur prélevée par échantillonnage,
un multiplieur (11) pour multiplier ensemble la valeur de sortie du premier moyen convertisseur analogique/numérique (3) et la valeur de sortie correspondante du second moyen convertisseur analogique/numérique (4) pour fournir une valeur de puissance instantanée b(n), où la valeur de puissance b(n) correspond à la n-ième action d'échantillonnage, et
un moyen de calcul de valeur moyenne (8) pour recevoir la valeur de puissance instantanée b(n) et une dernière valeur moyenne P(n-1) calculée par lui-même qui couvre les n-1 actions d'échantillonnage et pour réaliser le calcul de l'équation suivante :$\text{P(n) = P(n-1) + (1/G) . {b(n) - P(n-1)}}$
sur les deux valeurs reçues en utilisant une constante prédéterminée 1/G, où 1/G<< 1, pour fournir une valeur moyenne actuelle P(n) couvrant les n actions d'échantillonnage.

2. Dispositif de mesure du type à échantillonnage selon la revendication 1, dans lequel le moyen de calcul de valeur moyenne est composé de :
un premier moyen (15) pour recevoir la dernière valeur moyenne P(n-1) du moyen de mémoire (14) et la valeur de puissance instantanée actuelle b(n) du multiplieur (11) et pour calculer la différence, b(n) - P(n-1), entre les deux valeurs reçues,
un second moyen (16) pour multiplier la valeur de sortie, b(n) - P(n-1), du premier moyen (15) par la constante 1/G, et
un troisième moyen (17) pour calculer la somme, P(n) = P(n-1) + 1/G. {b(n) - P(n-1)}, à partir de la dernière valeur moyenne P(n-1) du moyen de mémoire (14) et à partir de la valeur de sortie du second moyen (16) et pour stocker la valeur moyenne actuelle P(n) dans le moyen de mémoire (14).

3. Dispositif de mesure du type à échantillonnage pour mesurer un signal d'entrée analogique en réalisant un échantillonnage du signal d'entrée analogique à une certaine période, une conversion sous forme numérique de chaque valeur moyenne prélevée par échantillonnage, et un traitement des valeurs numériques, qui comprend :
un moyen convertisseur analogique/numérique (3) pour réaliser un échantillonnage du signal d'entrée analogique et une conversion sous forme numérique de chaque valeur prélevée par échantillonnage,
une unité arithmétique de calcul de valeur absolue (25) pour obtenir la valeur absolue g(n) de la valeur de sortie du moyen convertisseur analogique/numérique (3), où la valeur absolue g(n) correspond à la n-ième action d'échantillonnage, et
un moyen de calcul de valeur moyenne (8) pour recevoir la valeur absolue actuelle g(n) et une dernière valeur moyenne Q(n-1) calculée par lui-même qui couvre les n-1 actions d'échantillonnage et pour réaliser le calcul de l'équation suivante :$\text{Q(n) = Q(n-1) + (1/G). {g(n) - Q(n-1))}$
sur les deux valeurs reçues en utilisant une constante prédéterminée 1/G, où 1/G<< 1, pour fournir une valeur moyenne actuelle Q(n) couvrant les n actions d'échantillonnage.

4. Dispositif de mesure du type à échantillonnage pour mesurer un signal d'entrée analogique en réalisant un échantillonnage du signal d'entrée analogique à une certaine période, une conversion sous forme numérique de chaque valeur prélevée par échantillonnage, et un traitement des valeurs numériques, qui comprend :
un moyen convertisseur analogique/numérique (3) pour réaliser un échantillonnage d'un signal d'entrée analogique et une conversion sous forme numérique de chaque valeur prélevée par échantillonnage,
une unité arithmétique d'élévation au carré (26) pour réaliser un calcul d'élévation au carré de la valeur de sortie du moyen convertisseur analogique/numérique (3) pour fournir la valeur d'élévation au carré h(n), où la valeur d'élévation au carré h(n) correspond à la n-ième action d'échantillonnage,
un moyen de calcul de valeur moyenne (8) pour recevoir la valeur d'élévation au carré h(n) et une dernière valeur moyenne R(n-1) couvrant les n-1 actions d'échantillonnage et pour réaliser le calcul de l'équation suivante :$\text{R(n) = R(n-1) + (1/G). {h(n) - R(n-1)}}$
sur les deux valeurs reçues en utilisant une constante prédéterminée 1/G, où 1/G<<1, pour fournir une valeur moyenne actuelle R(n) couvrant les n actions d'échantillonnage, et
une unité arithmétique de calcul de racine carrée (27) pour réaliser un calcul de racine carrée de la valeur de sortie du moyen de calcul de valeur moyenne (8).
